**Europäisches Patentamt**

**European Patent Office**

**Office européen des brevets**

(11) Veröffentlichungsnummer: **0 072 342**
A2

## (12) EUROPÄISCHE PATENTANMELDUNG

(21) Anmeldenummer: **82730103.7**

(22) Anmeldetag: **03.08.82**

(51) Int. Cl.³: **G 01 D 1/00**, G 06 F 3/05

(30) Priorität: **03.08.81 JP 120724/81**

(43) Veröffentlichungstag der Anmeldung: **16.02.83**
**Patentblatt 83/7**

(84) Benannte Vertragsstaaten: **CH DE FR GB IT LI**

(71) Anmelder: **FUJI ELECTRIC CO. LTD., 1-1,
Tanabeshinden, Kawasaki-ku, Kawasaki 210 (JP)**

(72) Erfinder: **Yasuhara, Takeshi, Dipl.-Ing., 7-20,
Kita 4-chome Asagaya Suginami-ku, Tokyo (JP)**
Erfinder: **Nabeta, Eiichi, Dipl.-Ing., No. 205,
Mitsuba-Corpo 5-35-9, Honchoh Koganei-shi, Tokyo (JP)**

(74) Vertreter: **Mehl, Ernst, Dipl.-Ing. et al, Postfach 22 01 76,
D-8000 München 22 (DE)**

(54) **Messanordnung mit einer Messeinrichtung für eine physikalische Grösse.**

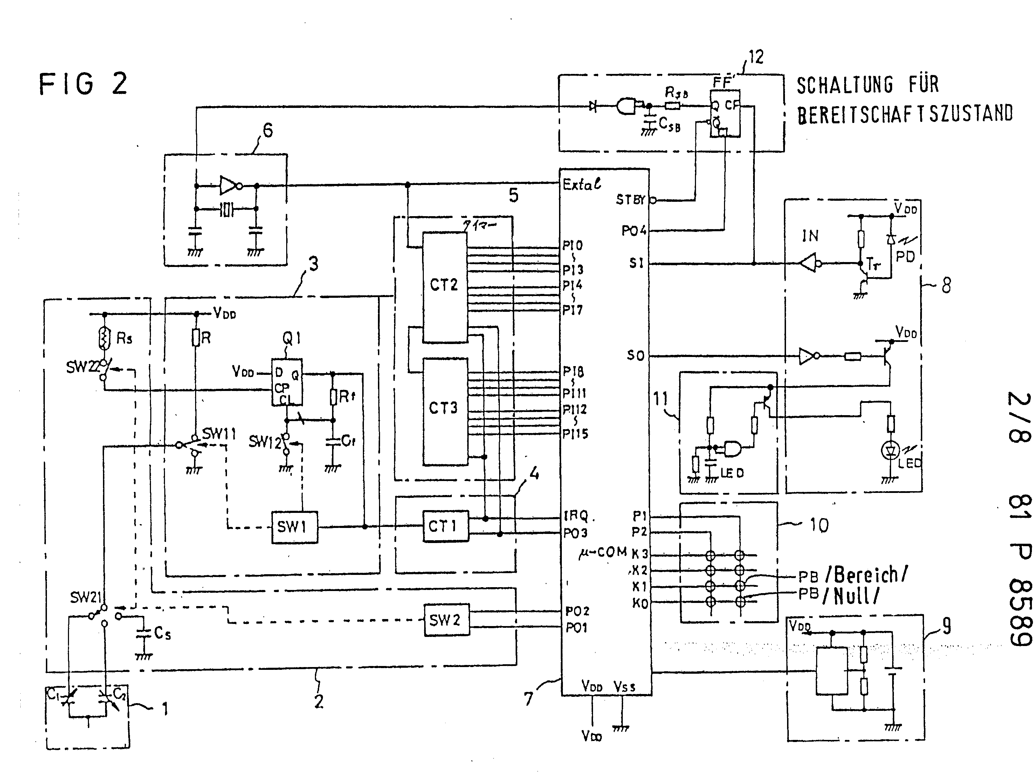

(57) Eine Messeinrichtung bestimmt eine physikalische Grösse nach ihrer Erfassung durch Umwandlung in eine digitale Grösse, die vorbestimmten Rechenoperationen unterzogen wird. Eine übergeordnete Prozessoreinheit gibt einen Steuerbefehl zur Inbetriebsetzung der Messeinrichtung sowie ein Setzsignal ab, durch das eine bistabile Schaltung (FF) setzbar ist. Sind die vorbestimmten Rechenoperationen in einer digitalen Prozessoreinheit (7) der Messeinheit durchgeführt, so wird hierdurch die bistabile Schaltung (FF) zurückgestellt. Eine Verzögerungs-schaltung ($R_{SB}$, $C_{SB}$) verzögert eine Ausgangsgrösse der bistabilen Schaltung (FF) um eine vorbestimmte Zeit und sorgt für die Stillsetzung der digitalen Prozessoreinheit (7) nach einer für ihre Überführung in einen Bereitschaftszustand erforderlichen Zeit. Die Messeinrichtung ist insbesondere zur Messung eines Druckes oder eines Differenzdruckes geeignet. (Fig. 2)

ACTORUM AG

FUJI ELECTRIC CO., LTD
Kawasaki / Japan

Mein Zeichen 0072342
VPA **81 P 8 5 8 9** E

**Meßanordnung mit einer Meßeinrichtung für eine physikalische Größe**

Die Erfindung befaßt sich mit einer Meßanordnung mit einer
Meßeinrichtung für eine physikalische Größe, bei der die
physikalische Größe nach ihrer Erfassung in eine digitale
Größe umgewandelt und diese vorbestimmten Rechenoperationen
unterzogen wird.

Soll eine Meßeinrichtung dieser Art durch eine Batterie
betrieben werden, so ergibt sich in Abhängigkeit von dem
Energieverbrauch der Meßeinrichtung einer mehr oder weniger
beschränkte Lebensdauer der Batterie. Der Erfindung liegt
in diesem Zusammenhang die Aufgabe zugrunde, den Energiebedarf der Meßeinrichtung zu verringern.

Diese Aufgabe wird gemäß der Erfindung durch folgende Merkmale gelöst:
a) eine digitale Prozessoreinheit zur Durchführung der
   Rechenoperationen,
b) einen Taktsignalgenerator,
c) eine übergeordnete Prozessoreinheit zur Abgabe eines
   Steuerbefehls zur Inbetriebsetzung der Meßeinrichtung,
d) eine bistabile Schaltung, die
   d1) durch den Steuerbefehl setzbar ist und
   d2) durch Beendigung der Rechenoperationen der digitalen
       Prozessoreinheit zurückstellbar ist
e) eine Verzögerungsschaltung, die
   e1) eine Ausgangsgröße der bistabilen Schaltung um eine
       vorbestimmte Zeit verzögert und
   e2) das verzögerte Signal an den Taktsignalgenerator
       weiterleitet und hierdurch den Betrieb der digitalen
       Prozessoreinheit nach einer für ihre Überführung
       in einen Bereitschaftszustand erforderlichen Zeit
       beendet.

Et 3 Sby / 02.08.1982

Hierdurch wird erreicht, daß die Prozessoreinheit mit ihrem verhältnismäßig großen Energiebedarf und der Taktsignalgenerator nur intermittierend in Betrieb sind, d. h. der Taktsignalgenerator wird abgeschaltet und die Prozessoreinheit wird in einen Bereitschaftszustand umgeschaltet, wenn diese Geräte nicht in Betrieb zu sein brauchen oder die Meßeinrichtung im Ruhezustand bleiben soll.

Die Erfindung wird im folgenden anhand der in den Figuren dargestellten Ausführungsbeispiele näher erläutert.

Die Fig. 1 ist ein Blockschaltbild einer Ausführungsform der Erfindung.

Die Fig. 2 ist ein ausführliches Schaltbild des Ausführungsbeispieles gemäß der Fig. 1.

In Fig. 3 ist das Prinzip der Umwandlung einer mechanischen Verstellung in einen Kapazitätswert dargestellt.

Die Fig. 4 ist ein Ablaufdiagramm von Vorgängen innerhalb der Schaltung gemäß der Fig. 2.

Die Fig. 5 ist ein Schaltbild eines Kapazitätsdetektors nach einer weiteren Ausführungsform.

Die Fig. 6 zeigt Schaltungen unterschiedlicher Widerstandsdetektoren.

Die Fig. 7 ist ein Schaltbild eines Frequenzdetektors.

In der Fig. 8 ist das Schaltbild eines Spannungsdetektors gezeigt.

Die Fig. 9 und 11 sind Ablaufdiagramme zur Veranschaulichung der intermittierenden Betriebsweise der Meßeinrichtung.

Die Fig. 10 ist ein Blockschaltbild eines Systems, bei dem eine Vielzahl von Meßeinrichtungen mit einer zentralen Prozessoreinheit zur Informationsübertragung verbunden sind.

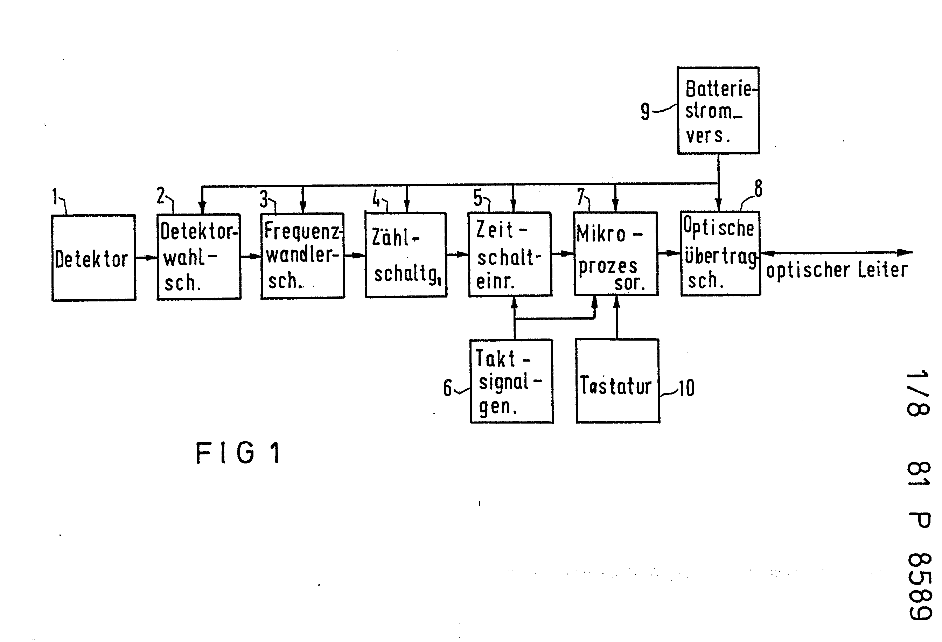

Die Meßeinrichtung gemäß der Fig. 1 umfaßt einen Detektor 1, eine Detektorwahlschaltung 2, eine Frequenzwandlerschaltung 3, eine Zählschaltung 4, eine Zeitschalteinrichtung 5, eine Taktsignalgeneratorschaltung 6, einen Mikroprozessor 7, eine optische Übertragungsschaltung 8, eine Stromversorgungsschaltung 9 mit einer Batterie und eine Tastatur 10.

Der Fig. 2 ist zu entnehmen, daß der Detektor 1 zwei Kondensatoren $C_1$ und $C_2$ aufweist. Ferner ist die Detektorwahlschaltung 2 aus einem Analogschalter SW2 (SW21 und SW22) vom CMOS-Typ zur Wahl der Kondensatoren $C_1$ und $C_2$ sowie einem Kondensator Cf zur Temperaturmessung oder einem Thermistor Rs zusammengesetzt. Die Frequenzwandlerschaltung 3 umfaßt einen Analogschalter SW1 (SW11 und SW12) zur Umschaltung, zur Aufladung und Entladung der Kondensatoren $C_1$ und $C_2$ sowie zur Rückstellung einer Kippschaltung Q1 vom sogenannten D-Typ. Diese Kippschaltung kann gesetzt werden, wenn die Ladespannung der Kondensatoren $C_1$ oder $C_2$ einen bestimmten Spannungspegel (Schwellspannung) überschreitet und kann nach dem Verstreichen einer durch einen Widerstand Rs und einen Kondensator Cs bestimmten Zeitkonstante gegebenen Zeit zurückgestellt werden. Wenn eine Kippschaltung Q1 eine übliche Kippschaltung vom D-Typ verwendet wird, benötigt man eine spezielle Schaltung (wie z. B. einen Schmitt-Trigger) in einer Eingangsstufe der Kippschaltung, um die Schwellspannung festzulegen. Verwendet man dagegen eine Kippschaltung in CMOS-Technik, so wird keine solche spezielle Schaltung benötigt und die Schaltspannung kann als Schwellspannung benutzt werden. Die Zeitschalteinrichtung 5 enthält zwei Zählschaltungen CT2 und CT3, die mit dem Zählen der Impulse der Taktsignalgeneratorschaltung 6 beginnen so bald ein Rückstellsignal PO3 des
Mikroprozessors 7 aufgehoben ist und beendet das Zählen
der Signale aufgrund eines von der Zählschaltung 4 (CT1)
gelieferten Zählschlußsignals. Der Mikroprozessor 7 wird
mit Taktsignalen betrieben, die von der Taktsignalgeneratorschaltung 6 bereitgestellt werden, um eine Reihe von Rechenoperationen und Steuervorgängen zu bewirken.

Zum Beispiel gibt der Mikroprozessor 7 ein Betriebsartwahlsignal PO1 oder PO2 an den Analogschalter SW2, der Detektorwahlschaltung 2 ab, um eine Betriebsart zur Messung
des Kondensators $C_1$, eine Betriebsart zur Messung des Kondensators $C_2$ oder eine Betriebsart zur Messung von Temperaturen unter Verwendung des Widerstandes Rs und des Kondensators Cs zu wählen. Wenn keine Messung durchgeführt
wird, gibt der Mikroprozessor 7 ein Rückstellsignal PO3 an
die Zählschaltung 4 und die Zeitschalteinrichtung 5 ab,
um diese zurückzustellen. Sollen Messungen durchgeführt
werden, hebt der Mikroprozessor 7 das Rückstellsignal PO3
auf, um zu ermöglichen, daß die Zählschaltung 4 und die
Zeitschalteinrichtung 5 Zählvorgänge durchführen können.
Der Mikroprozessor 7 empfängt das Zählschlußsignal von der
Zählschaltung 4 als ein Unterbrechungssignal IRQ und liest
eine Zählerausgangsgröße aus der Zeitschalteinrichtung 5
durch die Anschlüsse PI1 bis PI15 zur Durchführung vorbestimmter Rechenoperationen.

Der Mikroprozessor 7 ist mit der optischen Übertragungsschaltung 8 verbunden, die aus einer lichtaussendenden
Diode LED und einer Fotodiode PD zusammengesetzt ist, um
optische Informationen auszusenden oder um optische Informationen von einem übergeordneten Computer in einem Kontrollraum, von der Tastatur und einer Erfassungsschaltung
11 zur Erfassung eines fehlerhaften Betriebes der Leuchtdiode LED (z. B. unbeabsichtigte Dauererregung) zu empfangen.
Wesentlich für die Erfindung ist eine Bereitschaftsschaltung
12 zur intermittierenden Betätigung des Taktsignalgenera-

0072342

tors 6 und des Mikroprozessors 7, um die von diesen Geräten benötigte Betriebsenergie zu senken. Die Batteriestromversorgung 9 dient zur Speisung der verschiedenen in den Fig. 1 und 2 gezeigten Teile.

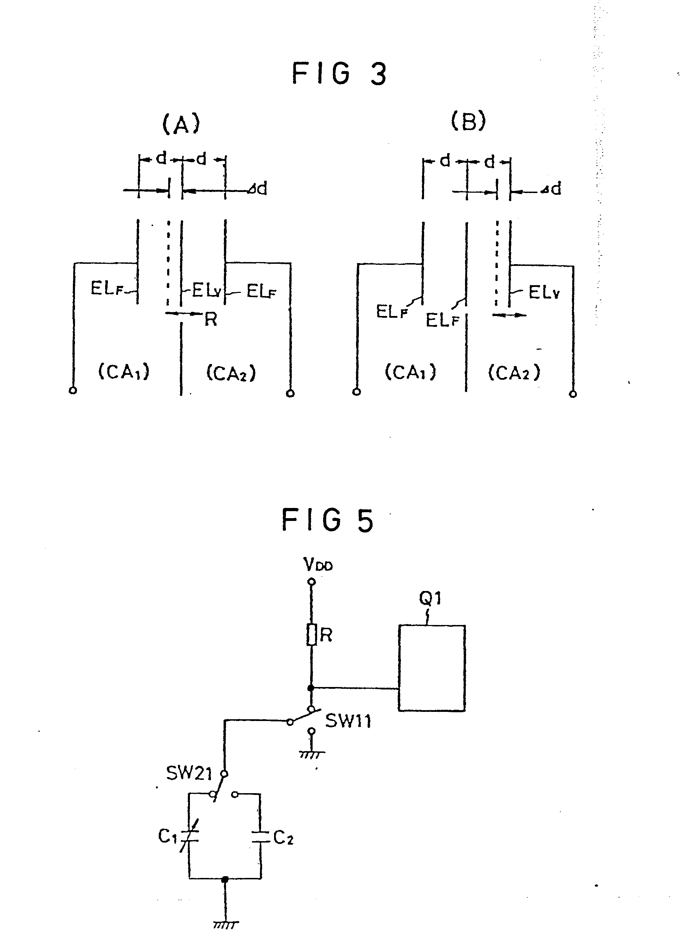

Die gezeigte Meßeinrichtung dient zur Umwandlung einer mechanischen Verstellung aufgrund eines Druckes in eine Kapazität und wandelt ferner einen in dieser Weise erfaßten Wert in eine digitale Größe um. Das Prinzip dieser Meßwerterfassung wird anhand der Fig. 3 beschrieben.

Wie die Fig. 3A zeigt, ist eine bewegbare Elektrode $EL_V$ zwischen zwei feststehenden Elektroden $EL_F$ angeordnet, wobei die bewegbare Elektrode $EL_V$ seitlich in den mit dem Pfeil R bezeichneten Richtungen verschiebbar ist aufgrund einer mechanischen Verstellung, die z. B. durch einen Druck hervorgerufen wird. Die Kapazitäten $CA_1$, $CA_2$ zwischen den Elektroden verändern sich differentiell, d. h. wenn sich eine der Kapazitäten vergrößert, nimmt die andere Kapazität ab. Wenn die bewegbare Elektrode $EL_V$ um einen Betrag $\Delta$d entsprechend der gestrichelten Linie in Fig. 3A verschoben wird, können die Kapazitäten $CA_1$ und $CA_2$ folgendermaßen ausgedrückt werden:

$$CA_1 = A/(d - \Delta d)$$
$$CA_2 = A/(d + \Delta d)$$

Hierin bedeutet $\mathcal{E}$ die Dielektrizitätskonstante zwischen den Elektroden und d den Abstand zwischen der bewegbaren Elektrode $EL_V$ und den feststehenden Elektroden $EL_F$, bevor die bewegbare Elektrode $EL_V$ verstellt wird. Die Summe und die Differenz der Kapazitäten lautet:

$$CA_1 + CA_2 = \mathcal{E} A . 2d/(d^2 - \Delta d^2)$$

$$CA_1 - CA_2 = \mathcal{E} A . 2 \Delta d/(d^2 - \Delta d^2)$$

Das Verhältnis zwischen der Summe und der Differenz beträgt

$$(CA_1 - CA_2)/(CA_1 + CA_2) = \Delta d/d$$

Somit kann die Verstellung $\triangle$d aus dem Verhältnis der Kapazitäten $(CA_1 - CA_2)/(CA_1 + CA_2)$ abgeleitet werden.

In der Fig. 3B nimmt die bewegbare Elektrode $EL_V$ die gezeigte Stellung bezüglich der beiden feststehenden Elektroden $EL_F$ ein. Wenn die bewegbare Elektrode $EL_V$ um den Betrag $\Delta$d aufgrund eines von außen angewandten Druckes verstellt wird, können eine feste Kapazität $CA_1$ und eine veränderliche Kapazität $CA_2$ ausgedrückt werden als

$$CA_1 = \{ A/d, \quad CA_2 = \{ A/(d + \Delta d)$$

Die Differenz zwischen den Kapazitäten beträgt

$$CA_1 - CA_2 = \{ A \cdot \Delta d/d(d + \Delta d)$$

Das Verhältnis der Differenz ($CA_1$ - $CA_2$) zu der Kapazität $CA_2$ lautet wie folgt

$$(CA_1 - CA_2)/CA_2 = \triangle d/d$$

In jedem Fall kann die Verstellung $\triangle d$ als Funktion der elektrostatischen Kapazitäten ausgedrückt werden. Die vorstehenden Gleichungen zeigen auch, daß die Verstellung nur eine Funktion der Kapazität ist und aus diesem Grunde durch die Dielektrizitätskonstante zwischen den Elektroden und Streukapazitäten nicht nennenswert beeinträchtigt wird. Mechanische Verstellungen lassen sich somit mit äußerster Genauigkeit aus den Kapazitäten bestimmen.

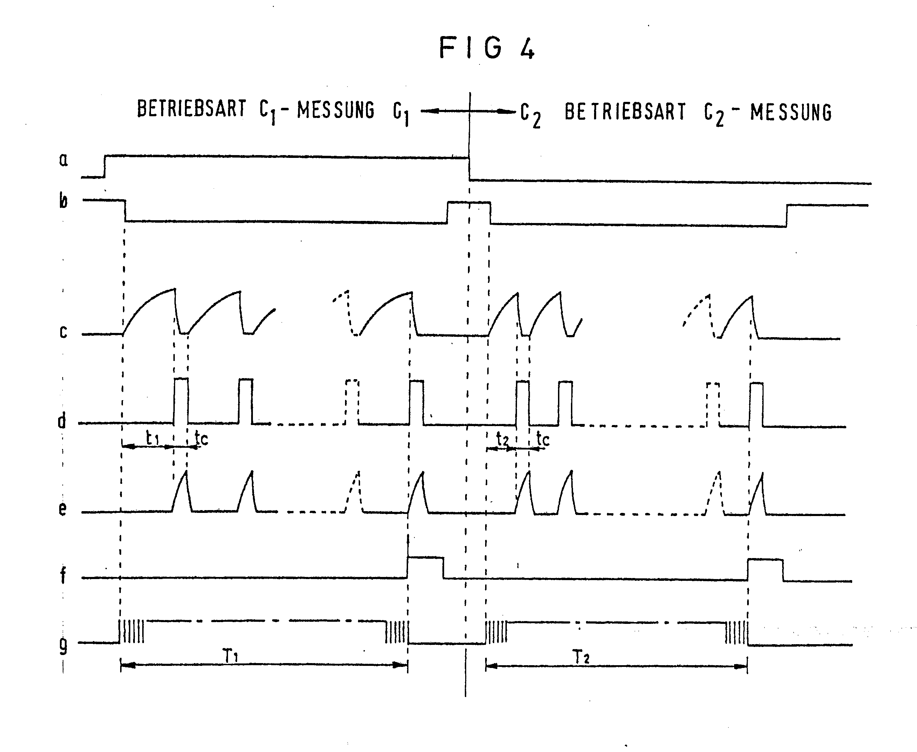

Auf dem vorstehend erläuterten Prinzip beruhende Meßvorgänge werden im folgenden hauptsächlich anhand der Fig. 2 und 4 erläutert.

In einem Anfangsstadium werden von dem Mikroprozessor 7 keine Betriebsartwahlsignale PO1 und PO2 abgegeben und die Zählschaltung 4 (CT1) und die Zeitschalteinrichtung 5 verbleiben durch das Signal PO3 zurückgestellt. Wenn das Signal für die Betriebsart zur Messung des Kondensators $C_1$ wie bei (a) in Fig. 4 gezeigt angelegt wird, um das Rückstellsignal PO3 entsprechend (b) in Fig. 4 aufzuheben, wird ein Stromkreis geschlossen, der sich von dem Kondensator $C_1$ zu den Schaltern SW21 und SW11 zu dem Widerstand R und zu der Stromversorgung $V_{DD}$ erstreckt, worauf der Kondensator $C_1$ wie bei (c) gezeigt aufgeladen wird. Wenn die Ladespannung des Kondensators $C_1$ die Schwellspannung $V_{TH}$ der Kippschaltung Q1 nach Ablauf einer Zeit $t_1$ überschreitet, wird die Kippschaltung Q1 gesetzt und gibt an ihrem Ausgang Q eine Ausgangsgröße ab. Diese Ausgangsgröße wird an den Widerstand Rf und den Kondensator Cf sowie an den Analogschalter FW1 angelegt. Als Ergebnis wird der Schalter SW12 geöffnet, um einen Ladestromkreis aus dem Widerstand Rf und dem Kondensator Cf zu schließen. Zu dieser Zeit wird der Schalter SW11 in die gestrichelte Position zur Entladung des Kondensators $C_1$ gebracht. Wenn die Ladespannung des Kondensators Cf einen vorbestimmten Pegel nach Ablauf einer Zeit $t_C$ erreicht, wie bei (e) in Fig. 4 gezeigt, wird die Kippschaltung Q1 zurückgesetzt, die darauf einen Ausgangsimpuls mit einer Breite $t_C$ abgibt, wie dies bei (d) in Fig. 4 dargestellt ist. Da der Analogschalter SW1 zur selben Zeit abgeschaltet wird, zu der die Kippschaltung Q1 zurückgesetzt wird, kehrt der Schalter SW12 in die in Fig. 2 gezeigte Stellung zurück und schließt einen Entladungsstromkreis für den Kondensator Cf. Da die Zeitspanne $t_1$ der Kapazität des Kondensators $C_1$ und dem Widerstandswert des Widerstandes R proportional ist, erscheint am Ausgangsanschluß der Kippschaltung Q1 ein Impulssignal mit einer Frequenz, die dem Kapazitätswert des Kondensators $C_1$ proportional ist. Das von der Kippschaltung Q1 abgegebene Impulssignal wird durch die Zählschaltung 4 gezählt. Wenn der Zählerstand der Zählschaltung 4 eine vorbestimmte Zahl erreicht, gibt die Zählschaltung 4 einen Impuls ab (Zählschlußsignal), wie dies bei (f) in der Fig. 4 angegeben ist, wodurch der Betrieb der Zeitschalteinrichtung 5, wie bei (g) in Fig. 4 gezeigt, beendet wird. Die Zeitschalteinrichtung 5 hat in dieser Zeit von dem Taktsignalgenerator 6 nach Aufhebung des Rückstellsignals PO3 abgegebene Taktsignalimpulse gezählt. Der Zählerstand der Zeitschalteinrichtung 5 wird mittels der Anschlüsse PI1 bis PI15 durch den Mikroprozessor 7 bei dem Empfang des von der Zählschaltung 4 abgegebenen Zählschlußsignals ausgelesen.

Die Schwellspannung $V_{TH}$ der Kippschaltung Q1 beträgt

$$V_{TH} = V_{DD} \left( 1 - e^{-\frac{t_1}{RC_1}} \right)$$

Die zur Aufladung des Kondensators $C_1$ benötigte Zeit $t_1$ (vgl. (d) in Fig. 4) kann ausgedrückt werden durch

$$t_1 = -RC_1 \log_e (1 - \frac{V_{TH}}{V_{DD}})$$

Die Zeitspanne $t_C$ kann dementsprechend angegeben werden zu

$$t_C = R_f C_f \log_e (1 - \frac{V_{TH}}{V_{DD}})$$

Da Rf und Cf bekannte Größen sind, ist die Zeitspanne $t_C$ konstant. Dementsprechend kann eine Lade- und Entladezeit $T_1$ des Kondensators $C_1$ durch Zählen der Taktimpulse des Taktsignalgenerators 6 bestimmt werden, bis die Lade- und Entladevorgänge des Kondensators $C_1$ n-mal gezählt worden sind, d. h. durch eine Zählgröße der Zeitschalteinrichtung 5.

Da die Ladung während der Zeit $t_1$ n-mal bewirkt wird, während die Entladung für die Zeit $t_C$ (n - 1) durchgeführt wird, wie dies bei (d) in Fig. 4 veranschaulicht ist, kann die Lade- und Entladezeit $T_1$ wie folgt bestimmt werden

$$T_1 = nt_1 + (n - 1) t_C \qquad (I)$$

Die Lade- und Entladevorgänge werden n-mal gezählt, um die Auflösung der zeitmessenden Zähler (CT2, CT3) zu vergrößern und die Zahl n wird in Abhängigkeit von der Ausgangsfrequenz des Taktsignalgenerators 6 gewählt sowie in Abhängigkeit von dem Widerstandswert des Widerstandes R oder der Kapazität des Kondensators $C_1$.

Nachdem die Lade- und Entladezeit $T_1$ des Kondensators $C_1$ auf diese Weise gemessen worden ist (genaugenommen wird nur die Ladezeit $t_1$ gemessen), gibt der Mikroprozessor 7 einen Befehl PO1 oder PO2 ab, um den Schalter SW21 in die Betriebsart zur Messung des Kondensators $C_2$ durch Bestimmung der Lade- und Entladezeit dieses Kondensators umzuschalten. Der Vorgang zur Messung des Kondensators $C_2$ ist der

gleiche wie der zur Messung des Kondensators $C_1$ und wird daher im folgenden nicht beschrieben. Das Ablaufdiagramm zur Messung des Kondensators $C_2$ ist in der linken Hälfte der Fig. 4 dargestellt. Eine Lade- und Entladezeit $T_2$ des Kondensators $C_2$ beträgt ähnlich der Gleichung (I)

$$T_2 = nt_2 + (n - 1)t_C \qquad\qquad (II)$$

Aufgrund der Gleichungen (I) und (II) bewirkt der Mikroprozessor 7 folgende Rechenoperationen

$$T_1 + T_2 - 2(n - 1)t_C$$
$$= -R(C_1 + C_2)\log_e(1 - \frac{V_{TH}}{V_{DD}})$$

$$T_1 - T_2 = -R(C_1 - C_2)\log_e(1 - \frac{V_{TH}}{V_{DD}})$$

$$\frac{T_1 - T_2}{T_1 + T_2 - 2(n - 1)t_C} = \frac{C_1 + C_2}{C_1 - C_2} \qquad (III)$$

Die Gleichung (III) ist eine Funktion einer mechanischen Verstellung, wie unter Bezugnahme auf die Fig. 3 anhand der Beschreibung des Wirkungsprinzips zu entnehmen ist. Daher kann eine mechanische Verstellung durch die vorstehend angegebenen Rechenoperationen gemessen werden.

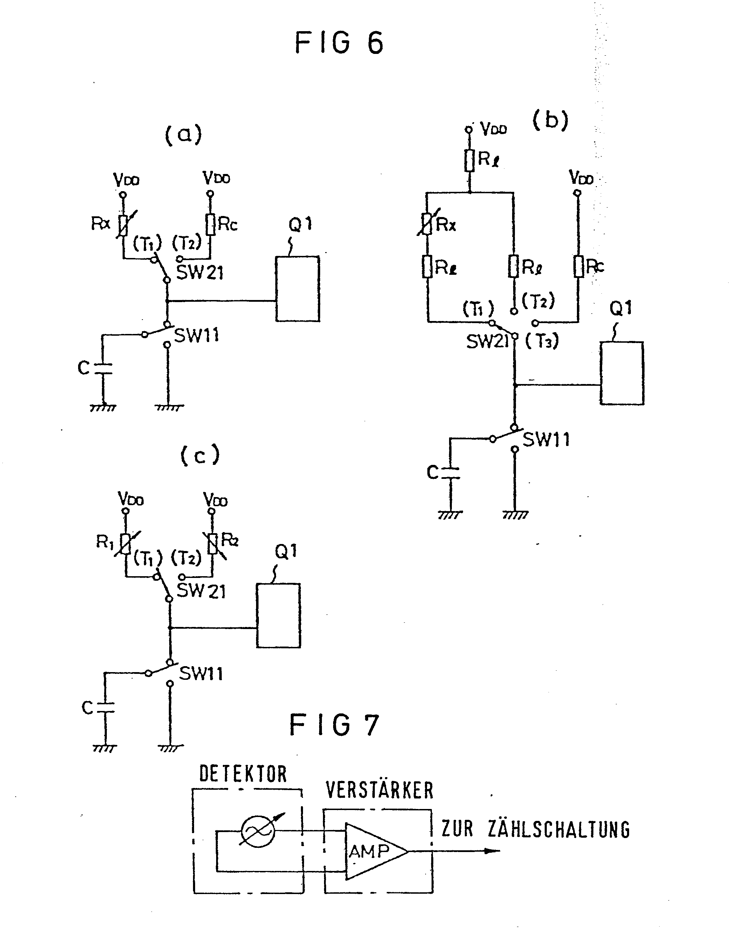

Während in den beschriebenen Ausführungsbeispielen die Kapazitäten der Kondensatoren $C_1$ und $C_2$ differentiell verändert werden, um die mechanische Verstellung, z. B. als ein Differentialdruck $\Delta P$ zu messen, können ein Kondensator $C_2$ mit fester Kapazität und ein veränderlicher Kondensator $C_1$ entsprechend der Fig. 5 benutzt werden, um die Messungen durchzuführen. Diese Abwandlung erfordert nur die Bestimmung eines Druckes P anstelle eines Differentialdruckes $\Delta P$. Der Druck P kann aus der folgenden Gleichung

0072342

abgeleitet werden

$$P = \frac{C_1 - C_2}{C_2} = \frac{T_1 - T_2}{T_2 - (n - 1)t_C}$$

Während in dem vorstehend beschriebenen Ausführungsbeispiel eine mechanische Verstellung in einen Kapazitätswert umgewandelt wird, kann die mechanische Verstellung auch nach Umwandlung in einen Widerstandswert, eine Frequenz oder eine Spannung erfaßt werden.

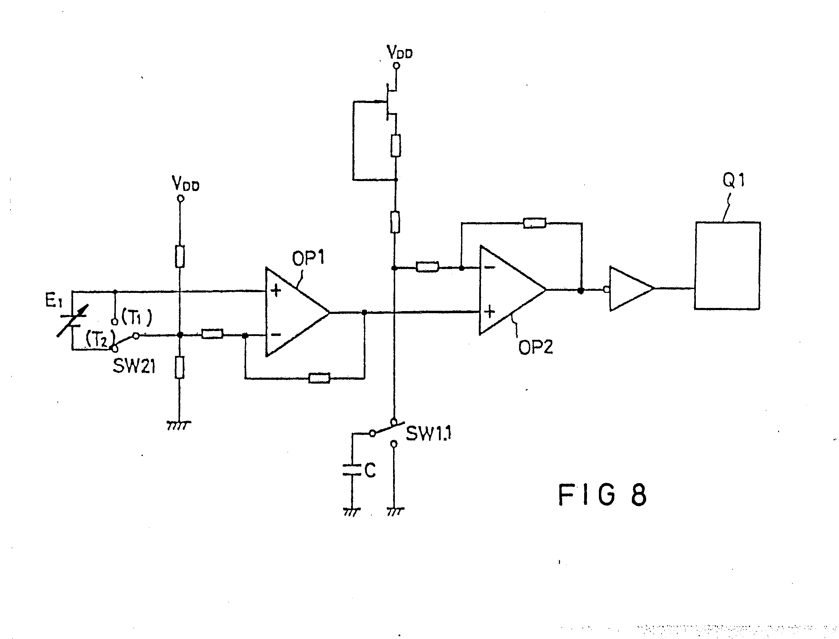

In den Fig. 6 bis 8 sind Schaltungen von Detektoren entsprechend weiteren Ausführungsformen der Erfindung dargestellt. Die Detektoren nach der Fig. 6 dienen zur Umwandlung einer mechanischen Verstellung in einen Widerstandswert. Der Detektor gemäß der Fig. 7 wandelt eine mechanische Verstellung in eine Frequenz um. Durch den Detektor gemäß der Fig. 8 kann eine mechanische Verstellung in eine Spannung umgewandelt werden.

In den Fig. 6 bis 8 sind der Kapazitätswert eines Kondensators C und der Widerstandswert eines Widerstandes $R_C$ bekannt, und die Schalter SW11, SW12 und eine Kippschaltung Q1 setzen den bereits in der Fig. 2 gezeigten Aufbau. Das in den Fig. 6a bis 6c gezeigte Erfassungsprinzip ist im wesentlichen das gleiche wie bei der Erfassung von Kapazitäten, wobei der Widerstandswert nach dem Prinzip bestimmt wird, das eine Lade- oder Entladezeit dem Produkt eines Widerstandes und einer Kapazität proportional ist. Insbesondere wird in der Fig. 6a der Schalter SW21 auf einen Widerstand $R_X$ geschaltet, um eine Lade- und Entladezeit $T_1$ des Kondensators C über den Widerstand $R_X$ zu bestimmen, und dann wird der Schalter SW21 auf den Widerstand $R_C$ umgeschaltet, um die Lade- und Entladezeit $T_2$ des Kondensators C durch den Widerstand $R_C$ zu bestimmen. Der Widerstandswert des Widerstandes $R_X$ kann anhand folgender Rechenoperationen abgeleitet werden

$$\frac{R_X}{R_C} = \frac{T_1 - (n - 1)t_C}{T_2 - (n - 1)t_C}$$

Die Detektoranordnung nach der Fig. 6c entspricht dem in Fig. 2 gezeigten Detektor mit der Ausnahme, daß die Kondensatoren $C_1$ und $C_2$ durch Widerstände $R_1$ und $R_2$ ersetzt sind. Die durchzuführende Rechenoperation kann daher in ähnlicher Weise wie folgt ausgedrückt werden:

$$\frac{T_1 - T_2}{T_1 + T_2 - 2(n - 1)t_C} = \frac{R_1 + R_2}{R_1 - R_2}$$

Der in Fig. 6b gezeigte Detektor wird benutzt, wenn ein Leitungswiderstand R veränderlich ist. Der Schalter SW21 wird aufeinanderfolgende umgeschaltet, um die Lade- und Entladezeiten $T_1$, $T_2$ und $T_3$ des Kondensators C über Widerstände $R_X + 2R$, 2R und $R_C$ zu bestimmen und der Widerstandswert $R_X$ kann aus folgender Rechenoperation erhalten werden

$$\frac{T_1 - T_2}{T_3 - (n - 1)t_C} = \frac{R_X}{R_C}$$

In dem Ausführungsbeispiel gemäß der Fig. 7 wird eine mechanische Verstellung durch einen Detektor in eine Frequenz umgewandelt, und aus diesem Grunde wird ein in der Fig. 2 gezeigter Frequenzumformer nicht benötigt. Eine Ausgangsgröße des Detektors wird verstärkt und dann direkt einer Zählschaltung eingegeben. Die Frequenz (N/T) kann ermittelt werden, indem eine Rechenoperation durchgeführt wird, um einen Zeitraum T zu bestimmen, den eine Zählschaltung zum Zählen einer vorgegebenen Zahl N benötigt.

Die Fig. 8 veranschaulicht einen Detektor zur Erfassung einer mechanischen Verstellung nach Umwandlung in eine Spannung $E_1$. Bei seinem Betrieb wird der Kondensator C mit einem konstantem Strom I aufgeladen und eine dem Ladestrom proportionale Spannung wird an einen Eingang eines
Operationsverstärkers OP2 angelegt, dessen anderem Eingang
die Spannung El angelegt wird, die durch einen anderen
Operationsverstärker OP1 verstärkt wird. Wenn die Ladespannung die zu messende Spannung überschreitet, setzt
der Operationsverstärker OP2 die Kippschaltung Q1 ein.
Da der Eingangsspannungspegel $E_1$ veränderlich ist, während
der Kondensator C konstant aufgeladen wird, kann ein von
der Spannung abhängiges Frequenzsignal erzeugt werden.
Die Spannung $E_1$ kann durch folgende Rechenoperation ermittelt werden

$$T_2 - T_1 = C_X/I \cdot E_1$$

worin $T_2$ die Ausgangsgröße der Zeitmessung bei in der dargestellten Stellung befindlichem Schalter SW21 ist, $T_1$
die Ausgangsgröße der Zeitmessung bei entgegengesetzter
Stellung befindlichem Schalter SW21, I der dem Kondensator C zugeführte konstante Strom und $C_X$ die Kapazität des
Kondensators C ist.

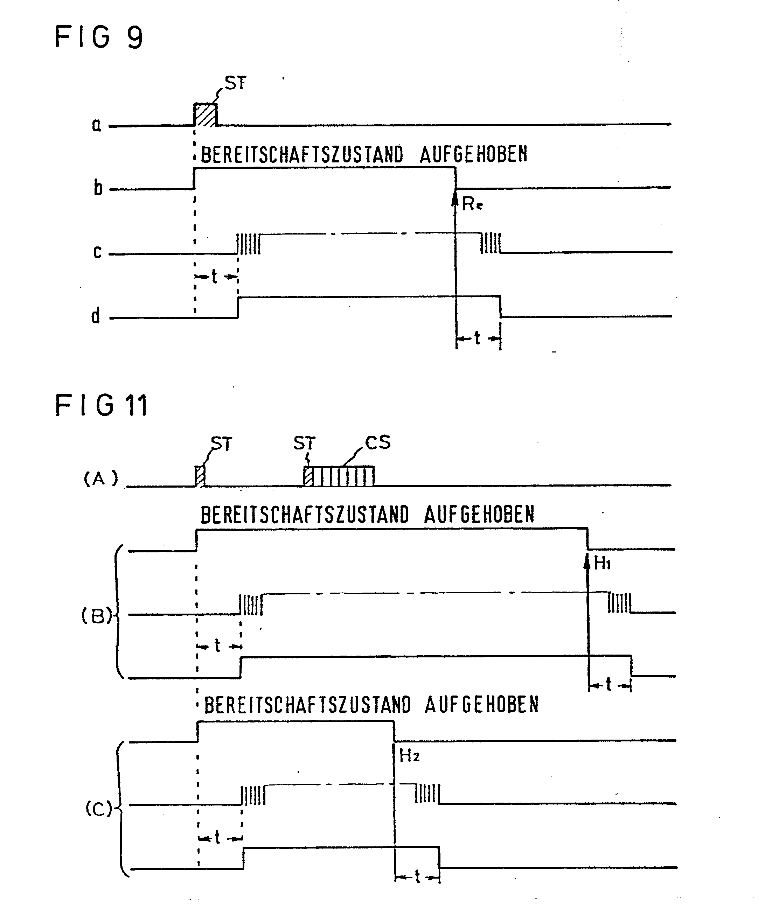

Der intermittierende Betrieb des Taktsignalgenerators 6
und des Mikroprozessors 7 der Meßeinrichtung mit dem vorstehend beschriebenen Aufbau wird nun anhand der Fig. 2
und 9 erläutert. Die Fig. 9 ist ein Ablaufdiagramm zur
Veranschaulichung des intermittierenden Betriebes.

Die Meßeinrichtung führt vorbestimmte Betriebsvorgänge
aufgrund von Steuerbefehlen einer zentralen Prozessoreinheit durch, die in einem zentralen Kontrollraum installiert ist. Beim Empfang eines Steuerbefehls (vgl. das Signal
ST bei (a) in Fig. 9) durch die Fotodiode PD wird der Transistor Tr durchgesteuert, worauf ein Signal mit niedrigem
Logikpegel an einen Inverter IN angelegt wird, der das
Signal invertiert und ein Signal mit hohem Logikpegel an
einen Eingang SI des Mikroprozessors 7 und einen Anschluß CP einer Kippschaltung FF anlegt. Die Kippschaltung FF ist nun gesetzt, und der Mikroprozessor 7, der sich bisher im Bereitschaftszustand befand, wird aus diesem Zustand freigegeben, wie (b) in Fig. 9 gezeigt. Eine gesetzte Ausgangsgröße der Kippschaltung FF über ihren Anschluß Q wird um eine gewisse Zeit t entsprechend der Darstellung (c) in Fig. 9 durch eine Verzögerungsschaltung verzögert, die aus einem Widerstand $R_{SB}$ und einem Kondensators $C_{SB}$ zusammengesetzt ist. Der Taktsignalgenerator 6 beginnt seinen Betrieb nach dem Ablauf der Zeit t, wie dies (c) in Fig. 9 gezeigt ist.

Sobald der Taktsignalgenerator 6 seinen Betrieb aufnimmt, beginnt der Mikroprozessor 7 mit der Durchführung vorbestimmter Rechenoperationen, wie bei (d) in Fig. 9 gezeigt, unter dem Einfluß von Steuerbefehlen der zentralen Prozessoreinheit. Sind diese vorbestimmten Rechenoperationen beendet, stellt der Mikroprozessor 7 die Kippschaltung FF durch den Anschluß PO4 (vgl. Pfeil Re in Fig. 9) zurück. Aufgrund eines Rückstellsignals, das als Ausgangsgröße an einem Anschluß $\overline{Q}$ der Kippschaltung FF erscheint, tritt der Mikroprozessor 7 in einen Bereitschaftszustand über. Zu dieser Zeit beenden der Taktsignalgenerator 6 und der Mikroprozessor 7 ihren Betrieb nicht augenblicklich, sondern werden um eine Zeit t verzögert inaktiviert.aufgrund der zwischen der Kippschaltung FF und dem Taktsignalgenerator 6 in der beschriebenen Weise eingefügten Verzögerungsschaltung. Anders ausgedrückt stellen der Taktsignalgenerator 6 und der Mikroprozessor 7 ihre Betriebsvorgänge ein, nachdem die Verzögerungsschaltung eine Zeitspanne t eingehalten hat, die benötigt wird, damit der Mikroprozessor 7 nach vollständiger Durchführung der vorbestimmten Rechenoperationen in den Bereitschaftszustand übergetreten ist.

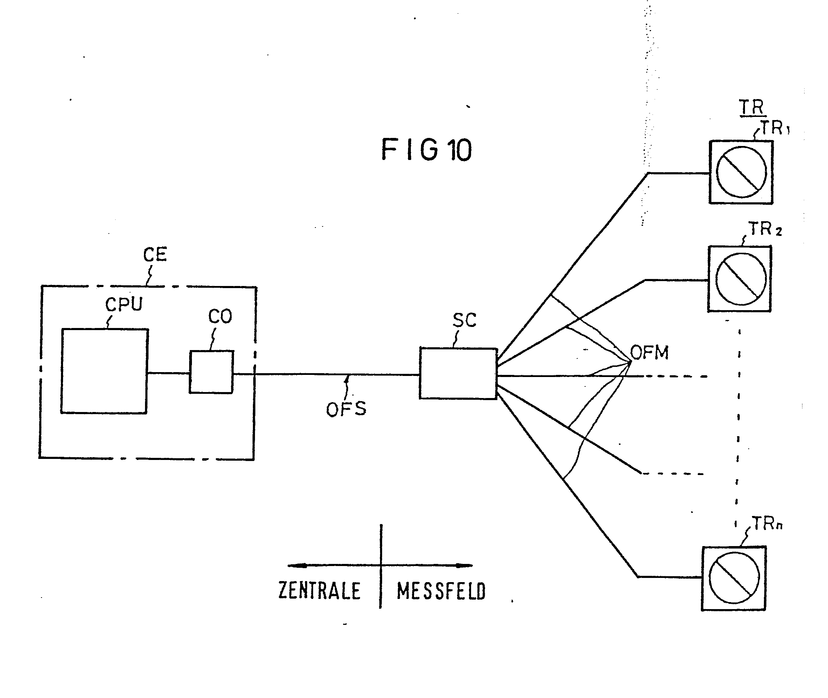

Die vorstehende Beschreibung richtet sich auf einen Betrieb für den Fall, daß zwischen der zentralen Prozessoreinheit und der Meßeinrichtung ein Austausch im Verhältnis 1 : 1
besteht. Anschließend wird eine parallele Betriebsweise
beschrieben für eine Anordnung, bei der eine Vielzahl von
Meßeinrichtungen mit einer einzigen Prozessoreinheit verbunden ist, wie dies die Fig. 10 zeigt. Die Fig. 10 ist
ein Blockschaltbild eines Systems zur Informationsübertragung aus einer Vielzahl von Meßeinrichtungen.

Das dargestellte System enthält einen zentralen Kontrollraum CE, eine zentrale Prozessoreinheit CPU, eine Wandler-
oder Sendeeinheit CO mit einem elektrisch/optisch wirkenden Wandler, einem optisch/elektrisch wirkenden Wandler
und ähnliche Teile, einen Sternkoppler SC zur Teilung optischer Signale von optischen Fasern OFS oder zur Kupplung optischer Signale von optischen Fasern OFM und eine
Vielzahl von Meßeinrichtungen $TR_1$ bis $TR_2$. Informationen
können in beiden Richtungen zwischen der Vielzahl von Meßeinrichtungen $TR_1$ bis $TR_2$ und der zentralen Prozessoreinheit CPU durch die optischen Fasern OFS und OFM und dem
optischen Teil- und Kuppelglied SC übertragen werden. Die
Wirkungsweise dieses Systems wird im folgenden nicht beschrieben, da dies zum Verständnis der Erfindung nicht
erforderlich ist.

Die zentrale Prozessoreinheit CPU kann eine gewünschte
Meßeinrichtung zur Übermittlung der Informationen oder
zum Empfang einer Information auswählen durch Abgabe einer
gemeinsamen Start- und Adresseninformation an die Meßeinrichtung. Der intermittierende Betrieb einer Vielzahl von
Meßeinrichtungen bei paralleler Betriebsweise wird im folgenden anhand der Fig. 11 beschrieben, die ein Ablaufdiagramm
darstellt. Die Vielzahl der Meßeinrichtungen wird gleichzeitig durch eine Startinformation (siehe ST bei (a) in
Fig. 11) eingeschaltet, die von der zentralen Prozessoreinheit CPU abgegeben wird und werden hierdurch aus den Bereitschaftszustand freigegeben. Der Taktsignalgenerator in jeder Meßeinrichtung wird dann nach dem Ablauf einer vorbestimmten Zeitverzögerung eingeschaltet. Alle Meßeinrichtungen arbeiten bis zu diesem Zeitpunkt in gleicher Weise. Dann werden einige der Meßeinrichtungen entsprechend der Darstellung (b) in Fig. 11 adressiert, während andere wie bei (C) in Fig. 11 gezeigt nicht adressiert werden. Die adressierten Meßeinrichtungen bewirken vorbestimmte Rechenoperationen und treten dann wie durch den Pfeil H1 in Fig. 1 angedeutet in den Bereitschaftszustand über, während die unadressierten Meßeinrichtungen in den Bereitschaftszustand nach dem Ablauf einer vorbestimmten Zeit übertreten entsprechend dem Pfeil H2 in Fig. 11. Somit werden sowohl die adressierten wie auch die unadressierten Meßeinrichtungen an einem unerwünschten Betrieb gehindert, wodurch ihr Energieverbrauch verringert wird. Bei der Anordnung nach der Erfindung werden der Taktsignalgenerator und der Mikroprozessor nur während bestimmter Zeiträume in Betrieb gesetzt. Die Meßeinrichtung hat somit den Vorteil, daß sie durch eine Batteriestromversorgung betrieben werden kann und ihr Energieverbrauch erheblich verringert ist.

1 Anspruch
11 Figuren

Patentanspruch

Meßanordnung mit einer Meßeinrichtung für eine physikalische Größe, bei der die physikalische Größe nach ihrer
Erfassung in eine digitale Größe umgewandelt und diese
vorbestimmten Rechenoperationen unterzogen wird,
g e k e n n z e i c h n e t   d u r c h   folgende Merkmale:

a) eine digitale Prozessoreinheit (7, Fig. 1, 2) zur
   Durchführung der Rechenoperationen,

b) ein Taktsignalgenerator (6, Fig. 1, 2),

c) eine übergeordnete Prozessoreinheit (CPU, Fig. 10) zur
   Abgabe eines Steuerbefehls (ST, Fig. 9) zur Inbetriebsetzung der Meßeinrichtung (1-10, Fig. 1; TR, Fig. 10)

d) eine bistabile Schaltung (FF, Fig. 2), die

   d1) durch den Steuerbefehl setzbar ist und

   d2) durch Beendigung der Rechenoperationen der digitalen Prozessoreinheit (7) rückstellbar ist (Re,
       Fig. 9)

e) eine Verzögerungsschaltung ($R_{SB}$, $C_{SB}$, Fig. 2), die

   e1) eine Ausgangsgröße (Q) der bistabilen Schaltung (FF)
       um eine vorbestimmte Zeit (t, Fig. 9) verzögert
       und

   e2) das verzögerte Signal an den Taktsignalgenerator
       (6, Fig. 2) weiterleitet und hierdurch den Betrieb
       der digitalen Prozessoreinheit (7) nach einer
       für ihre Überführung in einen Bereitschaftszustand
       erforderlichen Zeit (t) beendet.

Batterie-strom-vers.

9

1 Detektor

2 Detektor-wahl-sch.

3 Frequenz-wandler-sch.

4 Zähl-schaltg.

5 Zeit-schalt-einr.

7 Mikro-prozes-sor.

8 Optische übertrag sch.

optischer Leiter

6 Takt-signal-gen.

Tastatur 10

FIG 1

FIG 2

SCHALTUNG FÜR BEREITSCHAFTSZUSTAND

## FIG 3

(A)

$EL_F$  $EL_V$  $EL_F$  R

$(CA_1)$  $(CA_2)$

(B)

$EL_F$  $EL_F$  $EL_V$

$(CA_1)$  $(CA_2)$

## FIG 5

$V_{DD}$

R

Q1

SW11

SW21

$C_1$  $C_2$

FIG 4

BETRIEBSART $C_1$ - MESSUNG $C_1$ ← → $C_2$  BETRIEBSART $C_2$ - MESSUNG

4/8  81 P 8589

0072342

# FIG 6

(a)

(b)

(c)

# FIG 7

DETEKTOR    VERSTÄRKER

ZUR ZÄHLSCHALTUNG

AMP

FIG 8

0072342

FIG 9

ST

a

BEREITSCHAFTSZUSTAND  AUFGEHOBEN

b

Re

c

t

d

t

FIG 11

ST        ST        CS

(A)

BEREITSCHAFTSZUSTAND  AUFGEHOBEN

H₁

(B)

t

t

BEREITSCHAFTSZUSTAND  AUFGEHOBEN

H₂

(C)

t

t

FIG 10

ZENTRALE | MESSFELD